# EUROPEAN PATENT APPLICATION

(11) **EP 1 154 479 A2**
(43) Date of publication of application: **14.11.2001**
(21) Application number: 01111638.1
(22) Date of filing: 14.05.2001
(51) Int. Cl.: H01L 23/498

(54) **Multiple line grid for use in a packaging or a testing application**

(30) Priority: 13.05.2000 KR 2000025605
(71) Applicant: GLOTECH INC., KT Venture Center Rm. 403, Seoul (KR)
(72) Inventor: Yoon, Chong Kwang, Seongnam-shi, Kyounggi-do (KR); Kim, Young Soo, Seoul (KR)
(74) Representative: Lorenz, Werner, Dr.-Ing.

(57) **Abstract**

A multiple line grid for redistributing I/O pads from a peripheral array to an area array is disclosed. The multiple line grid includes a body having a top and a bottom surfaces, via holes, connection lines, upper bumps arranged in an area array and lower bumps arranged in tow peripheral/side arrays. Each of the via holes is provided with a first end exposed on the top surface and a second opposite end exposed on the bottom surface of the body. Each of the connection lines has a different length from the neighbouring connection lines. Each of the upper bumps is arranged to be in contact with the first end of the corresponding via hole. Each of the lower bumps is connected to the second end of the corresponding via hole through the corresponding connection line.

## Description

The present invention relates to a multiple line grid (MLG) for use in a packaging or a testing application and a method for the manufacture thereof; and, more particularly, to the MLG incorporated in a wafer level package to allow I/O pads to be redistributed from a peripheral array to an area array.

One of the most pronounced trends in the fabrication of modern semiconductor devices is the increase in device density, imposing more stringent requirements in the packaging or interconnecting methods.

One of the methods used in packaging of semiconductor chips capable of meeting those requirements has been the so-called flip-chip attachment method. In the flip-chip attachment method, instead of attaching a semiconductor chip to a lead frame in a package, an array of solder bumps is formed on the surface of the chip, using either an evaporation method or an electrodeposition method.

However, as a consequence of the with recent trend in the miniaturization of device dimensions, i.e. the increase in device density, and the accompanying reduction in bump-to-bump spacing (or pitch), the use of the solder bumps has become impractical for some of the chips, especially, the chips designed with a peripheral array of I/O pads, the reduced pitch acting as an obstacle in the formation of wirings on the package substrate, which, in turn, necessitating an I/O pad redistribution process whereby the peripheral array must be changed to an area array with a view to improving the pitch between the I/O pads.

It is, therefore, an object of the present invention to provide a novel structure capable of allowing an I/O redistribution from a peripheral array to an area array in interconnecting a semiconductor chip and another electronic circuit.

In accordance with the present invention, there is provided a multiple line grid including:
a body having a top and a bottom surfaces;
a plurality of via holes, each of the via holes extending from the top surface to the bottom surface and being provided with a first end exposed on the top surface and a second opposite end exposed on the bottom surface;
an identical number of connection lines as that of the via holes, each of the connection lines having a different length from the neighbouring connection lines;
an identical number of upper bumps as that of the via holes, each of the upper bumps being arranged to be in contact with the first end of the corresponding via hole; and
an identical number of lower bumps as that of the via hole, half of the lower bumps located on one periphery/side of the body and the other half, on the opposing periphery/side therefrom, each of the lower bumps being connected to the second end of the corresponding via hole through the corresponding connection line.

The above and other objects and features of the present invention will become apparent from the following description of preferred embodiments given with reference to the accompanying drawings in which:
- Fig. 1: is a perspective view setting forth a multiple line grid in accordance with the present invention;
- Figs. 2A and 2B: show a top view illustrating a top and a bottom surface of the multiple line grid shown in Fig. 1;
- Fig. 3: offers a schematic cross sectional view taken along A-A lines of Fig. 1;
- Fig. 4: provides a perspective view delineating a packaged semiconductor chip incorporating therein the multiple line grid in accordance with another embodiment of the present invention; and
- Fig. 5: represents a perspective view describing a testing device incorporating therein the multiple line grids in accordance with the present invention.

The present invention discloses a multiple line grid (MLG) for interconnecting an electronic component, e.g., a printed circuit board or the like, with a semiconductor chip having a number of I/O pads disposed on the periphery thereof.

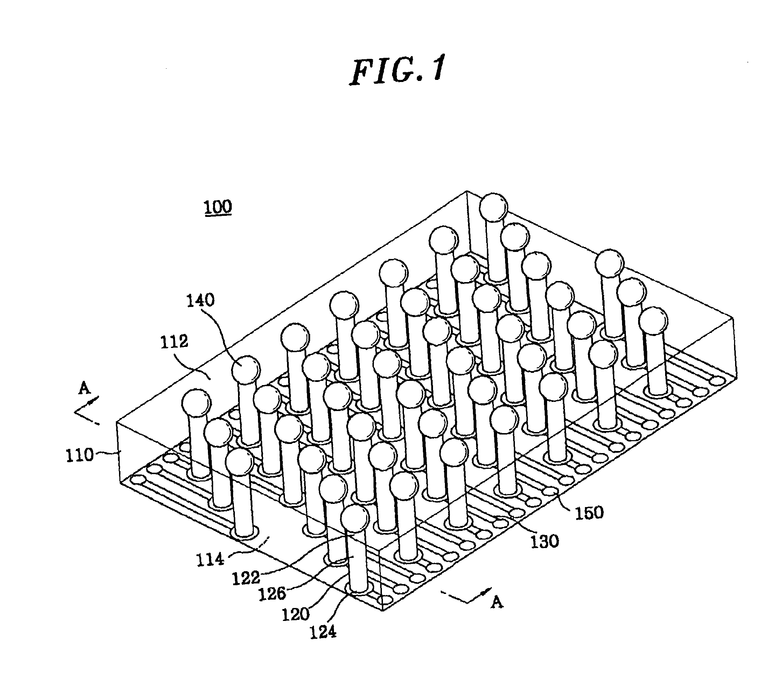

Fig. 1 shows the MLG 100 including a body 110 having a top and a bottom surfaces 112, 114, a plurality of via holes 120, each of the via holes extending from the top surface 112 to the bottom surface 114 of the body 110, an identical number of connection lines, upper and lower bumps 130,140,150, as that of the via holes 120, each connection line connecting one lower bump to one end of a via hole, and each upper bump 140 being formed at the opposite end from the end of the via hole connected to each of the lower bumps through the connecting line 130.

The body 110 is made of an insulating material, e.g., a ceramic, a polymer or a composite of ceramic and polymer.

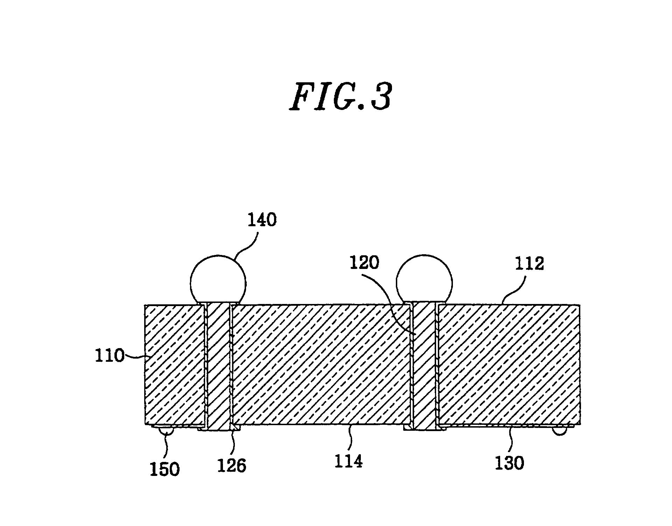

Each of the via holes 120 extends through the body 110 with a first end 122 exposed on the top surface 112 of the body 110 and a second opposite end 124 exposed on the bottom surface 114 thereof. Each of the via holes 120 includes a conductor 126 made of either a metal, e.g., Cu, Ni and Au, or an Ag-compound, e.g., Ag-Pt and Ag-Pd, containing glass components. The conductor 126 covers the inner surfaces of the via holes 120 and encompasses the first and the second end 122, 124 thereof, as shown in Fig. 3. Additionally, each of the via holes 120 covered by the conductor 126 may be filled with the conductor 126 or an electrically insulating material.

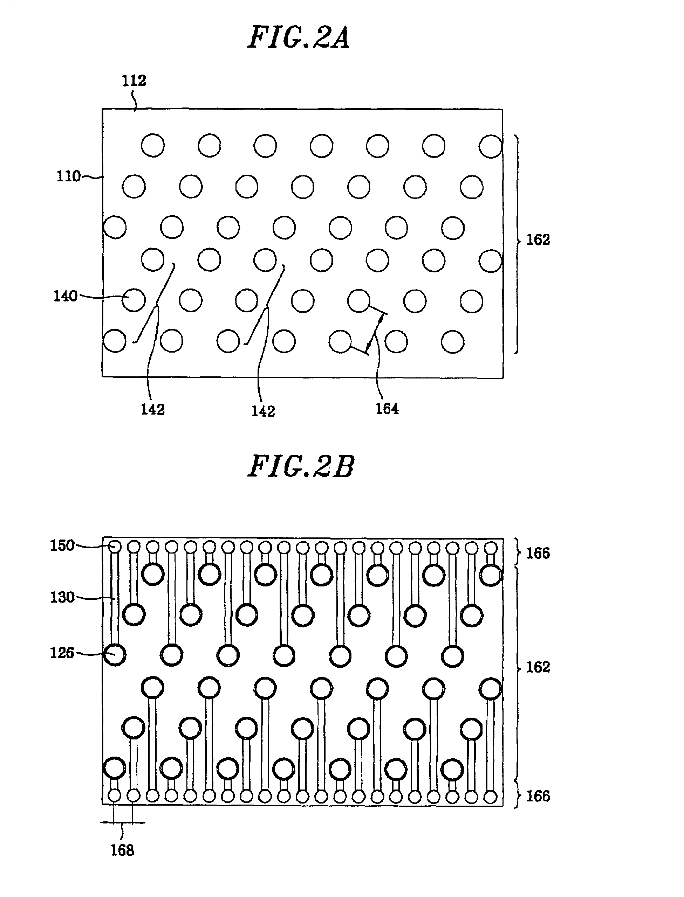

Returning to Fig. 1, each of the upper bumps 140 for securing the MLG 100 on, e.g., a printed circuit board, having connection pads thereon, is provided with a solder paste and is placed on the top surface 112 of the body 110 with a direct contact to the first end 122 of the corresponding via hole 120. As shown in Fig. 2A, the upper bumps 140 are disposed in the central region of the top surface 112 of the body 110 to form an array 162, the array 162 having a configuration such that all of the upper bumps 140 can be divided into a repetitive alignment of M number of groups 142, each group having N number of upper bumps 140, M, N being integers greater than 1. For example, in Fig. 2A, each of the group 142 includes three upper bumps 140, the bumps being regularly spaced apart with a first pitch 164.

Each of the lower bumps 150, to be used in mounting the multiple line grid 100 on a semiconductor chip having, e.g., connection pads on two opposing sides thereof, is made of, e.g., a solder paste, and is placed on the bottom surface 114 of the body 110. As shown in Fig. 2B, the lower bumps 150 are disposed along the two opposing peripheries/sides of the bottom surface 114 of the body 110 and regularly spaced apart with a second pitch 168 to form two peripheral arrays 166. The first pitch 164 is larger than the second pitch 168.

Each of the connection lines 130 is made of an electrically conducting material and is positioned on the bottom surface 114 of the body 110. The connection lines 130 rectilinearly extend in parallel from the second ends 124 of their corresponding via holes 120 to their corresponding lower bumps 150, thereby electrically connecting the conductor 126 of each of the via holes 120 to its corresponding lower bump 150. Each of the connection lines 130 is apart from the neighbouring connection lines 130 by the second pitch 168 and two neighbouring connection lines 130 differ in length.

A fabrication process of the multiple line grid 100 shown in Figs. 1 to 3 will be described hereinafter.

The insulating body 110 made of an insulating material, e.g., a ceramic, a polymer or a composite of ceramic and polymer, and having the top and the bottom surface 112, 114, is first prepared.

Next, the via holes 120 are formed to penetrate through the body 110 by using, e.g., a laser drilling or a punching method, wherein each of the via holes 120 is disposed to coincide with the first end of the corresponding connection line 130.

Subsequently, the via holes 120 are covered with the conductors 126. The conductors 126 are made of an Agcompound, e.g., Ag-Pt and Ag-Pd, containing a glass component if the body 110 is made of Al₂O₃, or of a metal, e.g., Cu, Ni or Au, if the body 110 is made of an insulating polymer or a composite of ceramic and polymer.

Thereafter, the connection lines 130 made of an electrical conducting material are formed on the bottom surface 114 of the body 110 by using, e.g., a screenprinting method with a mask and a solder reflow method. Each of the connection lines 130 is provided with a first one end thereof positioned at the central area of the body 110 and a second end placed at the peripheral/side area of the body 110, each of the connection lines 130 running parallel to each other.

Next, the lower bumps 150 are formed with a solder paste by using, e.g., a screen printing method and a solder reflow method, wherein each of the lower bumps 150 is positioned to coincide with the second end of the corresponding connection line 130.

Finally, the upper bumps 140 are formed with a solder paste, e.g., by using a screen printing method and a solder reflow method, wherein the upper bumps 140 are in contact with the via holes 120.

In the above method, a step for filling the via holes 120 should be added. This step can be achieved by either filling the via holes 120 with an insulating material, e.g., a solder ink, after the formation of the conductors 126, or filling the via holes 120 with the same material as the upper bumps 140, i.e., the solder paste, during the formation of the upper bumps 140.

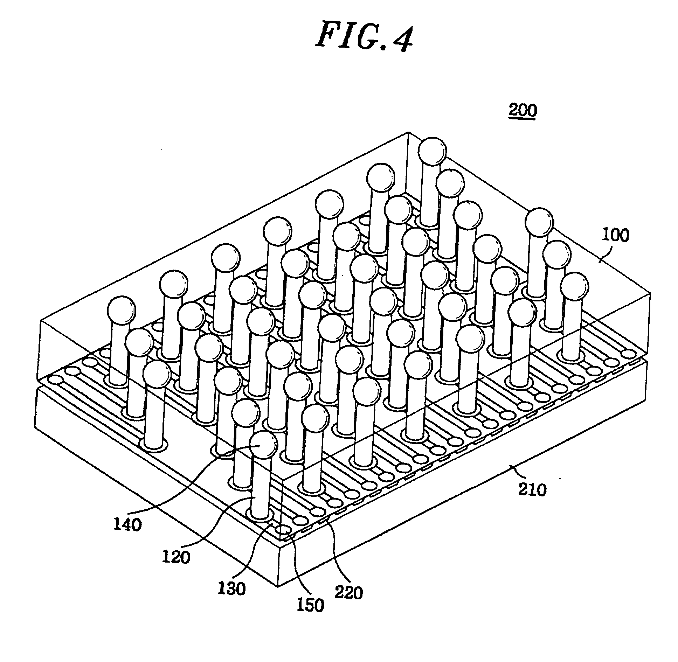

Fig. 4 is an example of the multiple line grid 100 utilized for packaging an electronic component, e.g., a chip. The chip package 200 includes a semiconductor chip 210 having, e.g., two peripheral/side arrays of I/O pads 220, each array having MN/2 I/O pads, and the multiple line grid 100. Each of the I/O pads 220 of the semiconductor chip 210 is bonded to the corresponding lower bump 150 of the multiple line grid 100, which, in turn, is electrically connected to the corresponding upper bump 140 through the corresponding connection line 130 and via hole 120. The chip package 200 can be mounted on a printed circuit board by using the upper bumps 140 of the multiple line grid 100. The multiple line grid 100 of the present invention allows the I/O pads to be easily redistributed, which, in turn, allows the semiconductor chip 210 having I/O pads with a pitch to be electrically connected to another circuitry, e.g., PCB, having a different I/O pad pitch.

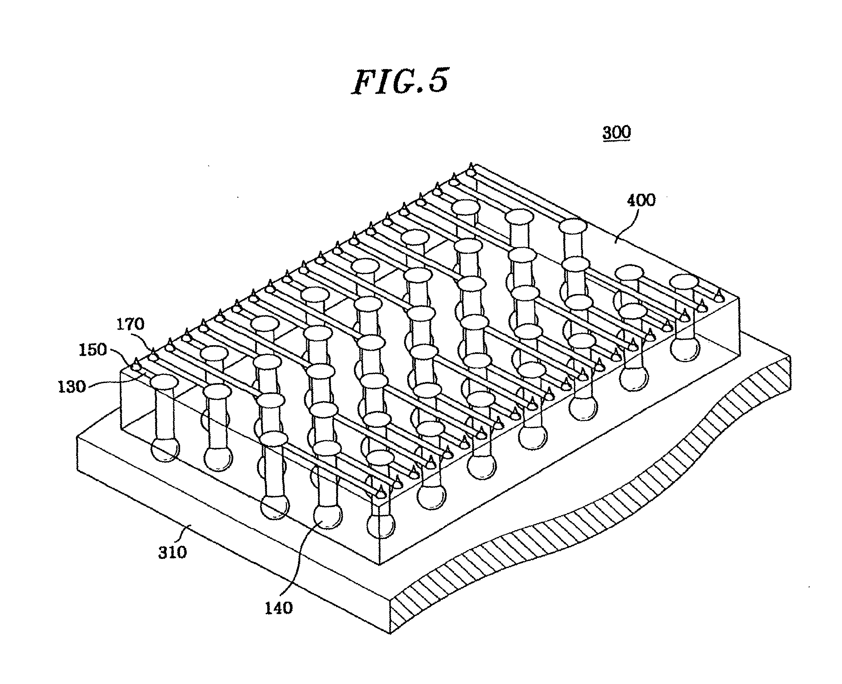

The ideas presented above can be further utilized in a chip testing application, as schematically illustrated in Fig. 5. The multiple line grid 400, shown in Fig 5, further includes a number of reading tips 170, each disposed on a corresponding lower bump 150. The multiple line grid 400 is mounted on a testing die 310, e.g., a chip-testing prove card, with the upper bumps 140 mechanically bonded and electrically connected to a testing circuit of the testing die 310, thereby forming a chip-testing device 300. In a chip workability test carried out prior to a packing process, the semiconductor chip is coupled to the testing device 300 with the reading tips 170 of the multiple line grid 100 being in contact with I/O pads of the semiconductor chip, in such a way that the semiconductor chip is electrically connected to the testing circuit of the testing die 310. Additionally, a plurality of multiple line grid 100 can be installed on the testing die 310 for testing a plurality of semiconductor chips integrated on a single wafer.

While the invention has been shown and described with respect to the preferred embodiments, it will be understood by those skilled in the art that various changes and modifications may be made without departing from the scope of the invention as defined in the following claims.

## Claims

1. A multiple line grid comprising:
a body having a top and a bottom surfaces;
a plurality of via holes, each of the via holes extending from the top surface to the bottom surface and being provided with a first end exposed on the top surface and a second opposite end exposed on the bottom surface;
an identical number of connection lines as that of the via holes, each of the connection lines having a different length from the neighbouring connection lines;
an identical number of upper bumps as that of the via holes, each of the upper bumps being arranged to be in contact with the first end of the corresponding via hole; and
an identical number of lower bumps as that of the via hole, half of the lower bumps located on one periphery/side of the body and the other half, on the opposing periphery/side therefrom, each of the lower bumps being connected to the second end of the corresponding via hole through the corresponding connection line.

2. The multiple line grid of claim 1, wherein the body is made of an insulating material selected from a group consisting of a ceramic, a polymer or a composite of ceramic and polymer.

3. The multiple line grid of claim 1, wherein each of the via holes is covered by a conductor made of an electrical conducting material selected from a group consisting of a metal and an Agcompound containing a glass component.

4. The multiple line grid of claim 3, wherein each of the via holes covered by the conductor is filled with an electrically conducting material.

5. The multiple line grid of claim 4, wherein each of the via holes covered by the conductor is filled with an electrically insulating material.

6. The multiple line grid of claim 1, wherein each of the connection lines is made of an electrically conducting material and rectilinearly extends from the lower bump to the second end of the via hole.

7. The multiple line grid of claim 6, wherein each of the connection lines is parallel to the neighbouring connection lines.

8. The multiple line grid of claim 1, wherein each of the upper bumps is made of a solder paste.

9. The multiple line grid of claim 1, wherein each of the lower bumps is made of a solder paste.

10. The multiple line grid of claim 1, wherein each of the upper bumps is arranged to form an area array and each of the lower bumps is arranged into two peripheral/side arrays.

11. The multiple line grid of claim 10, wherein the upper bumps are arranged into a repetitive configuration of a plurality of groups, the upper bumps being regularly spaced apart by a first pitch.

12. The multiple line grid of claim 11, wherein the lower bumps are regularly spaced apart by a second pitch.

13. The multiple line grid of claim 12, wherein the first pitch is greater than the second pitch.

14. A packaged semiconductor chip comprising a bare chip and said multiple line grid cited of claim 9, wherein the bare chip includes a number of I/O pads, each of the I/O pads of the bare chip being bonded to the corresponding lower bump of said multiple line grid.

15. A testing device for checking the workability of semiconductor chips comprising a testing board, an identical number of reading tips as that of the lower bumps and at least one said multiple line grid cited in claim 9, wherein the testing board includes a number of terminals, each of the terminals of the testing board being bonded to the corresponding upper bump of said multiple line grid and each of the tips being secured to the corresponding lower bump.
